# EUROPEAN PATENT SPECIFICATION

(11) **EP 3 460 783 B1**
(45) Date of publication and mention of the grant of the patent: **26.03.2025**
(21) Application number: 17799043.9
(22) Date of filing: 04.04.2017
(51) Int. Cl.: G09F 9/00, G02B 1/118, G02B 1/14, G02B 5/22

(54) **COVER COMPONENT AND TRANSFER FILM**
ABDECKUNGSKOMPONENTE UND TRANSFERFOLIE
ÉLÉMENT DE REVÊTEMENT ET FILTRE DE TRANSFERT

(30) Priority: 17.05.2016 JP 2016098347
(43) Date of publication of application: 27.03.2019
(73) Proprietor: Panasonic Intellectual Property Management Co., Ltd., Osaka-shi, Osaka 540-6207 (JP)
(72) Inventor: NAGAHARA Takayuki, Osaka-shi Osaka 540-6207 (JP); KANEUCHI Kazuhiko, Osaka-shi, Osaka 540-6207 (JP); NISHIMURA Tatsuya, Osaka-shi, Osaka 540-6207 (JP); YAMAMOTO Yasutaka, Osaka-shi, Osaka 540-6207 (JP); FURUICHI Suguru, Osaka-shi, Osaka 540-6207 (JP)
(74) Representative: Vigand, Philippe
(86) International application number: PCT/JP2017/014054
(87) International publication number: WO 2017/199609

(56) References cited:
- CN-U- 203 480 457
- JP-A- 2006 145 736
- JP-A- 2006 145 736
- JP-A- 2008 151 930
- JP-A- 2014 074 810
- JP-A- 2014 074 810
- JP-A- 2016 035 519
- JP-A- 2016 035 519
- JP-A- 2016 045 298
- US-A1- 2004 005 436
- US-A1- 2011 228 401
- US-A1- 2012 008 213
- US-A1- 2015 168 767
- US-A1- 2016 061 997

## Description

### TECHNICAL FIELD

The present disclosure relates to a cover component that covers a surface of a display panel of an in-vehicle display device, a mobile device, or the like and a transfer film used for manufacturing the cover component.

### BACKGROUND ART

In the related art, in an in-vehicle device, a mobile device, or the like having a display function, a cover component is used for the purpose of protecting a surface of a display panel such as a liquid crystal panel or an organic EL panel, preventing the surface from being stained, or decorating an edge of the display panel (For example, PTLs 1 and 2). Another cover component is known from JP2016-35519.

In such a cover component, for example, a hard coat layer having functions of protecting a display panel and preventing the display panel from being stained and a decorative layer having a decorating function are provided on a transparent substrate. The decorative layer includes a colored layer having a frame shape and a transmissive region provided inside the colored region. The transmissive region is a space for displaying contents of the display panel. The colored region is a region for imparting a design to the edge of the display panel.

The light generated from an inside of the display panel, such as backlight of the liquid crystal panel or light generated from the organic EL panel itself, may pass through the transmissive region and cause a viewer to dazzle. In addition, light outside the display panel, such as sunlight or illumination light, may reflect on the surface of the cover component to cause glitter (also called glare) to the viewer.

Therefore, in the hard coat layer, it is conceivable that a fine uneven shape is provided on a surface of a region overlapping with the transmissive region of the decorative layer. When providing the fine uneven shape on a surface of the hard coat layer, light from an inside of a display panel side and light from the outside of the display panel can be diffused in the hard coat layer and dazzling to the viewer can be reduced.

### Citation List - Patent Literature

PTL 1: Japanese Patent Unexamined Publication No. 2002-189107
PTL 2: Japanese Patent Unexamined Publication No. 2013-230652

### SUMMARY

The invention is as set out in the independents claims, further aspects of the invention are outlined in the dependent claims. Embodiments that do not fall within the scope of the claims do not describe part of the invention.

According to the cover component according to the present disclosure, the anti-reflection region having the fine uneven shape formed at least one surface covers the transmissive region and protrudes into the colored region over the whole inner peripheral portion of the colored region. Therefore, even when a positional shift occurs between the anti-reflection region and the transmissive region, since the anti-reflection region overlaps the transmissive region, it is possible to reduce the above-described light leakage and glare and prevent a quality of the cover component from deteriorating.

### BRIEF DESCRIPTION OF DRAWINGS

FIG. 1A is an exploded perspective view of a cover component according to Embodiment 1.
FIG. 1B is a plan view of the cover component of Embodiment 1.
FIG. 1C is a side sectional view of the cover component of Embodiment 1.
FIG. 2 is an enlarged sectional view illustrating a preferable aspect of a fine uneven shape of the cover component of Embodiment 1.
FIG. 3A is a plan view of a transfer film used for manufacturing the cover component of Embodiment 1.
FIG. 3B is a side sectional view of a transfer film of Embodiment 1.
FIG. 4A is a side sectional view of a manufacturing apparatus of the cover component of Embodiment 1.
FIG. 4B is a side sectional view of a manufacturing apparatus of Embodiment 1.
FIG. 5 is an enlarged sectional view illustrating a preferable aspect of a fine uneven shape of the manufacturing apparatus of Embodiment 1.
FIG. 6A is a plan view of a cover component of Embodiment 2.
FIG. 6B is a side sectional view of the cover component of Embodiment 2.
FIG. 7 is a schematic sectional view of a fine uneven shape of the manufacturing apparatus of the cover component of Embodiment 2.
FIG. 8A is an enlarged sectional view illustrating a preferable aspect of the fine uneven shape of the manufacturing apparatus of Embodiment 2.
FIG. 8B is an enlarged sectional view illustrating a preferable aspect of the fine uneven shape of the manufacturing apparatus of Embodiment 2.
FIG. 9A is a plan view of a cover component of Embodiment 3.
FIG. 9B is a side sectional view of the cover component of Embodiment 3.
FIG. 10A is a plan view of a transfer film used for manufacturing the cover component of Embodiment 3.
FIG. 10B is a side sectional view of a transfer film of Embodiment 3.

### DESCRIPTION OF THE EMBODIMENTS

Before explaining embodiments, problems in the related art will be briefly explained.

In a hard coat layer having functions of protecting a display panel and preventing the display panel from being stained, in an aspect in which a fine uneven shape is provided only in a region overlapping with a transmissive region, alignment between the fine uneven shape and the transmissive region has to be strictly performed. That is, when there is even a slight positional shift between the fine uneven shape and the transmissive region, a region where the fine uneven shape and the transmissive region do not overlap in plan view is generated. Light inside the display panel leaks from the non-overlapping region to the outside and may cause the viewer to dazzle. (Hereinafter, leakage of the light inside the display panel to the outside is simply referred to as "light leakage".). Light outside the display panel is reflected in the non-overlapping region to generate glare and may cause the viewer to dazzle.

An object of the present disclosure is to prevent the quality from deteriorating due to light leakage or glare, in a cover component of the display panel.

### (Embodiment 1)

### (1. Configuration of Cover Component)

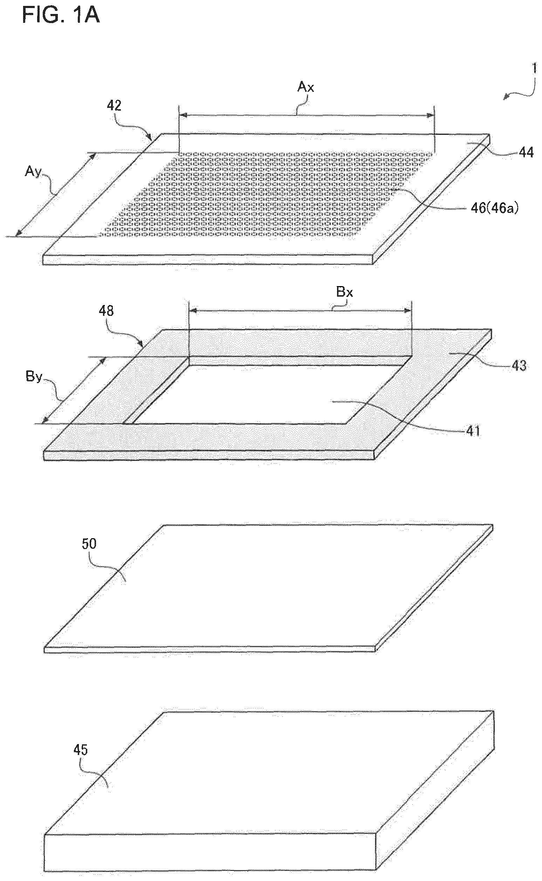

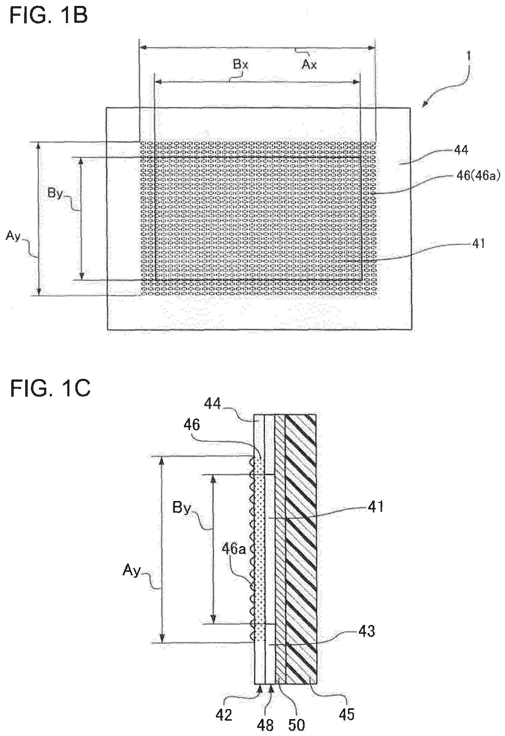

Hereinafter, cover component 1 of Embodiment 1 will be described with reference to the drawings. FIG. 1A is an exploded perspective view of cover component 1 of Embodiment 1. FIG. 1B is a plan view of cover component 1. FIG. 1C is a side sectional view of cover component 1. Cover component 1 is attached to a display panel of an in-vehicle display device, a mobile device, of the like and includes hard coat layer 42, decorative layer 48, adhesive layer 50, and transmissive substrate 45.

Hard coat layer 42 is a transparent resin layer such as a layer of polyethylene terephthalate (PET), and is provided at the outermost surface of cover component 1. Hard coat layer 42 overlaps decorative layer 48 below hard coat layer 42. Decorative layer 48 includes colored region 43 having a frame shape and transmissive region 41 provided inside the colored region. Transmissive region 41 is a space for displaying contents of the display panel. However, transmissive region 41 may be a light-transmissive material fitted inside colored region 43.

Adhesive layer 50 for bonding with transmissive substrate 45 is provided below decorative layer 48. A thickness of hard coat layer 42 is, for example, approximately 5 µm. A thickness of decorative layer 48 is, for example, approximately several µm. A thickness of adhesive layer 50 is, for example, approximately 1 to 5 µm. A thickness of transmissive substrate 45 is, for example, 2 mm.

Hard coat layer 42 includes anti-reflection region 46 and region 44 around anti-reflection region 46. Fine uneven shape 46a is provided on a surface of anti-reflection region 46. Anti-reflection region 46 covers transmissive region 41 of decorative layer 48 and protrudes into colored region 43 over a whole inner peripheral portion of colored region 43. That is, fine uneven shape 46a overlaps transmissive region 41 and protrudes to an inside of colored region 43 in a plan view (as viewed from a direction perpendicular to each layer). The surface of region 44 around anti-reflection region 46 has a smooth shape.

According to cover component 1 of the present embodiment, it is possible to prevent the quality of the cover component from deteriorating. For example, in hard coat layer 42, in an aspect in which a fine uneven shape is provided only in a region overlapping with transmissive region 41, alignment between anti-reflection region 46 and transmissive region has to be strictly performed. That is, when there is even a slight positional shift between anti-reflection region 46 and transmissive region 41, a region where anti-reflection region 46 and transmissive region 41 do not overlap in plan view is generated. Light inside the display panel, such as backlight or light generated from the organic EL leaks from the non-overlapping region to the outside and may cause the viewer to dazzle. In addition, light outside the display panel, such as sunlight or illumination light is reflected in the non-overlapping region to generate glare and may cause the viewer to dazzle.

On the other hand, according to cover component 1 of the present disclosure, anti-reflection region 46 in which fine uneven shape 46a is provided on a surface covers transmissive region 41 and protrudes into colored region 43 over the whole inner peripheral portion of colored region 43. Therefore, even when a positional shift occurs between anti-reflection region 46 and transmissive region 41, since anti-reflection region 46 overlaps transmissive region 41, it is possible to reduce the above-described light leakage and glare and prevent a quality of the cover component from deteriorating.

Here, in the present embodiment, transmissive region 41 and anti-reflection region 46 have rectangular shapes having a long side and a short side in plan view. When a length of the long side of anti-reflection region 46 is represented as Ax, a length of the short side of anti-reflection region 46 is represented as Ay, a length of the long side inside colored region 43 is represented as Bx, the length of the short side inside colored region 43 is By, and colored region 43 is positioned at the center of anti-reflection region 46 in plan view, it is preferable that conditions of 0.05 mm ≤ (Ax - Bx)/2 ≤ 0.25 mm and 0.05 mm ≤ (Ay - By)/2 ≤ 0.25 mm are satisfied. (Ax - Bx)/2 is a dimension that anti-reflection region 46 protrudes into colored region 43 in a long side direction. (Ay - By)/2 is a dimension that anti-reflection region 46 protrudes into colored region 43 in a short side direction.

In a case where a dimension that anti-reflection region 46 protrudes into colored region 43 is less than 0.05 mm in each side, a region in which anti-reflection region 46 and transmissive region 41 do not overlap when cover component 1 is viewed obliquely is generated, and light leakage and glare may occur. On the other hand, in a case where the dimension that anti-reflection region 46 protrudes into colored region 43 is more than 0.25 mm, fine uneven shape 46a becomes conspicuous in colored region 43. Therefore, there is a design problem. Accordingly, it is preferable to satisfy the above conditions. In the drawings, the dimension that anti-reflection region 46 protrudes into colored region 43 is drawn exaggeratingly in order to explain the contents of the present embodiment.

In fine uneven shape 46a provided on the surface of anti-reflection region 46, it is preferable that an arithmetic average roughness (Ra) is more than 0.08 µm and less than 0.2 µm and a root mean average roughness (Rms) is more than 80 nm and less than 200 nm. The reason why is as follows. In a case where the arithmetic average roughness (Ra) is 0.08 µm or less, the antiglare property decreases. On the other hand, in a case where the arithmetic average roughness (Ra) is more than 0.2 µm, a light diffusing effect increases and white blur in a screen occurs. In addition, the reason why is as follows. In a case where the root mean average roughness (Rms) is 80 nm or less, the antiglare property decreases. On the other hand, in a case where the root mean average roughness (Rms) is more than 200 nm, diffusion of light increases and the white blur in the screen occurs.

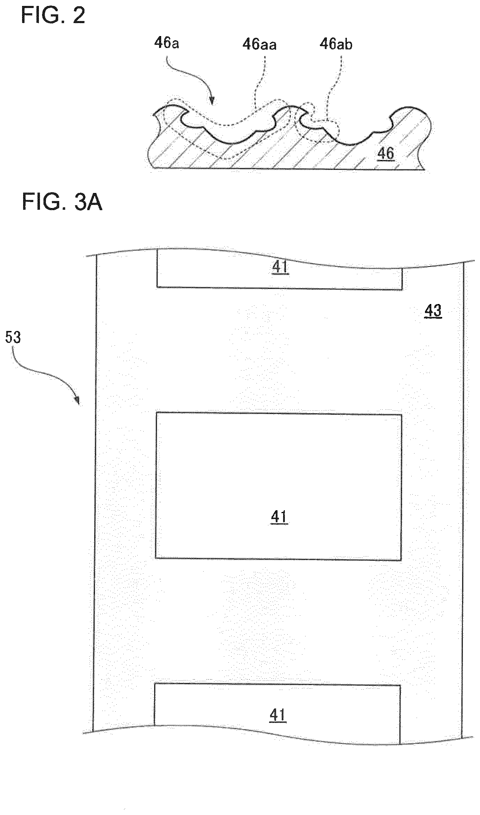

It is preferable that fine uneven shape 46a includes uneven shapes having two-steps of size (first uneven shape 46aa and second uneven shape 46ab) as shown in FIG 2. In the aspect shown in FIG. 2, first uneven shape 46aa is provided on the surface of anti-reflection region 46, and second uneven shape 46ab is provided on a surface of first uneven shape 46aa. First uneven shape 46aa has an arithmetic average roughness (Ra) of around 0.2 µm (for example, 0.15 µm or more and 0.25 µm or less) and a root mean average roughness (Rms) of around 200 nm (for example, 150 nm or more and 250 nm or less). Second uneven shape 46ab has an arithmetic average roughness (Ra) of around 0.08 µm (for example, 0.07 µm or more and 0.09 µm or less) and a root mean average roughness (Rms) of around 80 nm (for example, 70 nm or more and 90 nm or less). According to this aspect, it is possible to reduce glare due to pixel interference from the display panel with second uneven shape 46ab while securing antiglare property with first uneven shape 46aa, and it is possible to improve the quality of the cover component. For example, in a case where there is only first uneven shape 46aa, when a size of first uneven shape 46aa is close to a pixel size of the display panel, first uneven shape 46aa acts like a lens so that the pixel is enlarged, and the glare on a display of the display panel may occur. However, it is possible to prevent such glare from occurring by providing second uneven shape 46ab on the surface of first uneven shape 46aa.

A material of the transmissive substrate 45 is, for example, a general purpose resin to be formed, such as polycarbonate (PC) resin, poly(methylmethacrylate) (PMMA) resin, ABS resin, polystyrene (PS) resin, or polyolefin resin. In a case where transfer, UV (ultraviolet) exposure, or the like is used without using injection molding, it is also possible to cope with resin that requires forming at a high temperature, such as resin for optical applications or super engineering resin. A material of adhesive layer 50 is not particularly limited as long as the material has good adhesiveness with transmissive substrate 45.

Although the present embodiment adopts an aspect in which transmissive region 41 and anti-reflection region 46 each have rectangular shapes in plan view, the cover component of the present embodiment is not limited to the aspect. For example, shapes of transmissive region 41 and anti-reflection region 46 may be a circular shape, and shapes of transmissive region 41 and anti-reflection region 46 may be different from each other. As long as anti-reflection region 46 is formed to cover transmissive region 41 and protrude into colored region 43 over the whole inner peripheral portion of colored region 43, it is possible to achieve the object.

Although the present embodiment adopts an aspect in which fine uneven shape 46a is provided on the surface of anti-reflection region 46 of hard coat layer 42, the cover component of examples not falling under the scope of protection are not limited to the aspect. For example, fine uneven shape 46a may be provided on a back surface of anti-reflection region 46, that is, on decorative layer 48 side, or may also be provided on both the surface and the back surface (both surfaces). In other words, a fine uneven shape may be formed in at least one surface of anti-reflection region 46.

According to other examples not falling under the scope of protection, hard coat layer 42 may not include anti-reflection region 46 and an anti-reflection layer including an anti-reflection region may be separately provided. In other words, although the present embodiment adopts an aspect in which hard coat layer 42 having functions of protecting a display panel and preventing the display panel from being stained, also serves as a role of an anti-reflection layer having a function of anti-reflection, the cover component of the aspect may adopt an aspect in which a hard coat layer and an anti-reflection layer are separately provided.

### (2. Configuration of Transfer Film)

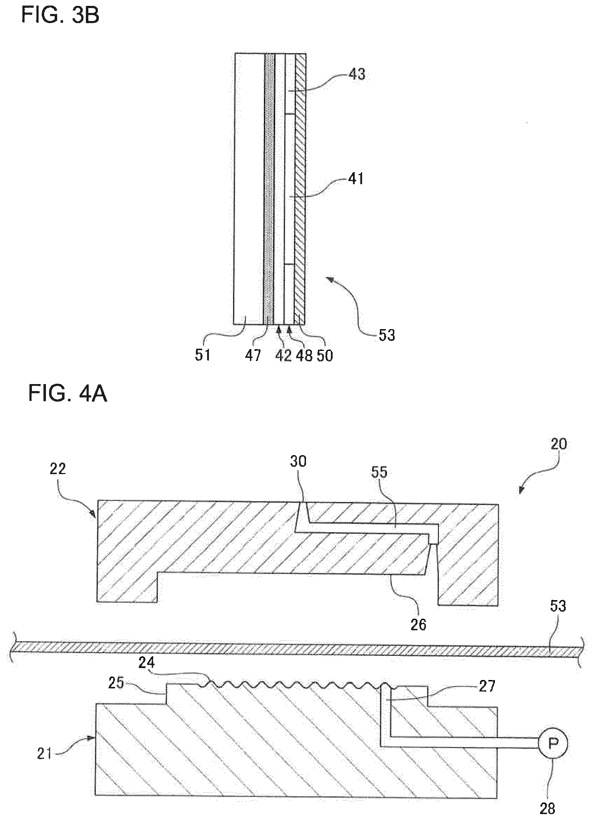

FIG. 3A is a plan view of a transfer film used for manufacturing the cover component of Embodiment 1. FIG. 3B is a sectional view of the transfer film. Transfer film 53 is formed by stacking base film 51, peelable layer 47, hard coat layer 42, decorative layer 48, and adhesive layer 50 in this order.

Base film 51 is a belt-like member, and is made of, for example, polyethylene terephthalate (PET). Since configurations of hard coat layer 42, decorative layer 48, and adhesive layer 50 are the same as the configurations of cover component 1, a detailed description of the same configurations will be omitted. Peelable layer 47 is interposed between base film 51 and hard coat layer 42. Hard coat layer 42 is made to be easily released from base film 51 by peelable layer 47.

Examples of methods for forming each of the layers on base film 51 include vacuum film formation, gravure printing, screen printing, and ink jet printing. In addition, in the present embodiment, in order to favorably form the fine uneven shape, it is preferable that hard coat layer 42 is an after-cure type in which UV (ultraviolet) curing is performed after forming.

### (3. Manufacturing Apparatus and Manufacturing Method of Cover Component)

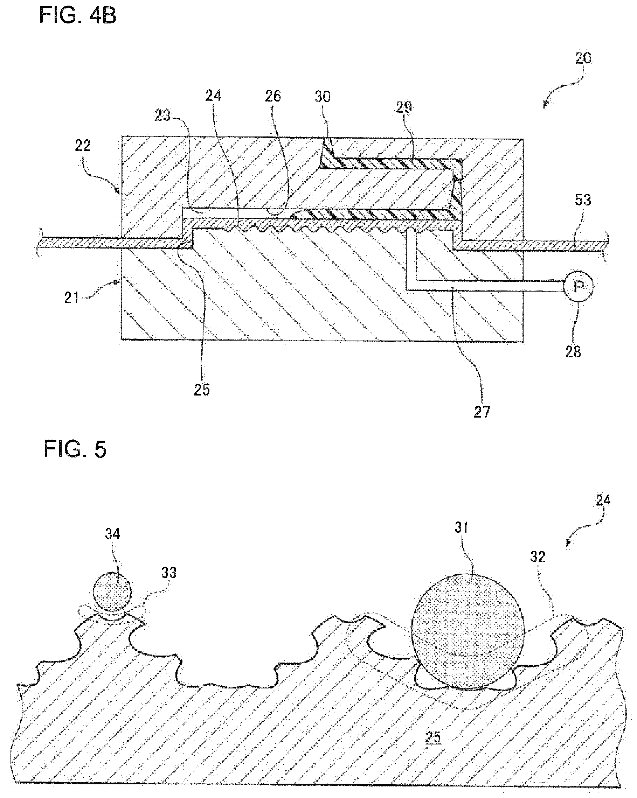

Hereinafter, examples of a manufacturing apparatus and a manufacturing method of the cover component of Embodiment 1 will be described with reference to FIGs. 4A to 5. The cover component of the present embodiment is manufactured by an insertion forming method by manufacturing apparatus 20. Manufacturing apparatus 20 includes: first die 21 having projection portion 25, suction hole 27, and vacuum pump 28; second die 22 having recess portion 26, spool 30, and hot liner 55; and a film feeding device (not shown). When first die 21 and second die 22 are clamped, as shown in FIG. 4B, projection portion 25 enters recess portion 26, and cavity 23 is formed between projection portion 25 and recess portion 26. Fine uneven shape 24 is formed on the surface of projection portion 25. Transfer film 53 is formed such that base film 51 (see FIG. 3B) faces fine uneven shape 24 and adhesive layer 50 (see FIG. 3B) faces recess portion 26 of second die 22.

First, as shown in FIG. 4A, transfer film 53 is fed by the film feeder to be positioned between first die 21 and second die 22. Thereafter, as shown in FIG. 4B, transfer film 53 is sandwiched and fixed between first die 21 and second die 22. When transfer film 53 is sucked with vacuum pump 28 via suction hole 27 of first die 21, transfer film 53 is caused to be in close contact with projection portion 25. Resin 29 is poured into cavity 23 from spool 30 of second die 22 through hot runner 55.

Thereafter, poured resin 29 solidifies and forms transmissive substrate 45 as shown in FIGs. 1A and 1C, and adheres to adhesive layer 50. Finally, hard coat layer 42 and peelable layer 47 shown in FIG. 3B are separated from each other by separating first die 21 and second die 22. Accordingly, cover component 1 of the present embodiment is completed.

At this time, fine uneven shape 24 of projection portion 25 is transferred to hard coat layer 42 via base film 51 and peelable layer 47. According to the manufacturing method, it is possible to obtain cover component 1 to which hard coat layer 42 having fine uneven shape 46a, decorative layer 48, and the like are transferred at the same time as forming transmissive substrate 45.

FIG. 5 is an enlarged sectional view of fine uneven shape 24 of projection portion 25 of first die 21. Two-steps of uneven shapes which are first uneven shape 32 and second uneven shape 33 are formed. That is, first uneven shape 32 is provided on the surface of projection portion 25, and second uneven shape 33 is provided on the surface of first uneven shape 32. In order to form such two-steps of uneven shapes, the following sand blasting method is exemplified.

When projecting glass bead 31 having a large diameter such as #60 (average particle diameter of 250 µm) to #80 (average particle diameter of 180 µm) to projection portion 25, first uneven shape 32 having an arithmetic average roughness (Ra) of approximately 1.2 µm, a root mean average roughness (Rms) of approximately 80 nm can be formed on the surface of projection portion 25. Thereafter, when projecting glass bead 34 having a small diameter such as #320 (average particle size of 46 µm) to #600 (average particle size of 24 µm) to projection portion 25, second uneven shape 33 having a root mean average roughness (Rms) of approximately 50 nm can be formed on the surface of first uneven shape 32.

In addition to the sand blasting method using glass beads, it is possible to form a similar fine multistage uneven shape by using etching, electroforming plating, or the like. Examples of a measuring device of such two-step uneven shapes include a laser microscope and a surface roughness measuring machine.

Although cover component 1 of the present embodiment adopts an aspect in which decorative layer 48 having colored region 43 is provided immediately below hard coat layer 42 having anti-reflection region 46, the cover component of the present embodiment is not limited to the aspect. For example, even in an aspect in which decorative layer 48 is provided below transmissive substrate 45, it is possible to achieve the object. In this case, transfer film 53 does not include decorative layer 48, and decorative layer 48 can be formed by forming transmissive substrate 45 by an insert forming method and then printing on transmissive substrate 45.

### (Embodiment 2)

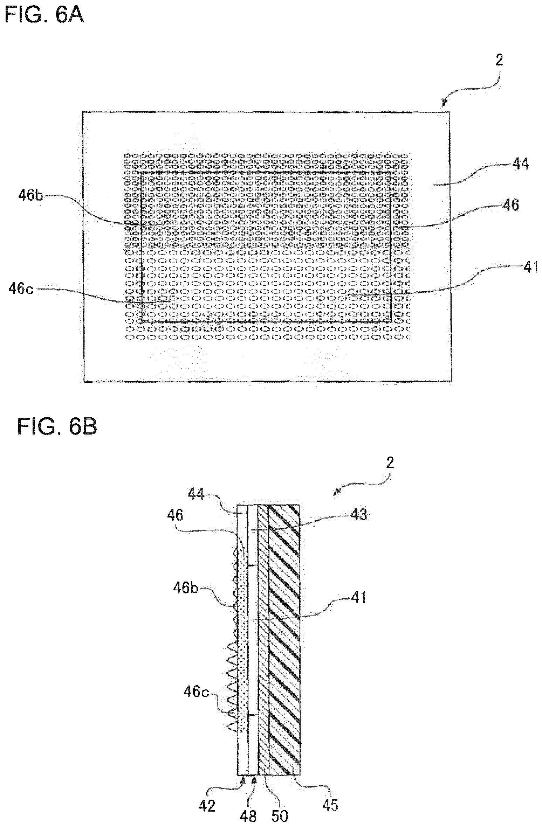

Hereinafter, cover component of Embodiment 2 will be described with reference to FIGs. 6A and 6B. In cover component 2 of the present embodiment, a surface of anti-reflection region 46 includes two kinds of fine uneven shapes 46b and 46c. Each of the two kinds of fine uneven shapes 46b and 46c has a different arithmetic average roughness (Ra) and a different root mean average roughness (Rms).

For example, in a case where the display panel is used in an inside of a vehicle, sunlight or the like is likely to be incident on a top of the display panel and may not easily enter a lower part. In this manner, in a case where the external light incident on the display panel is biased, when reducing the arithmetic average roughness and the root mean average roughness of the fine uneven shape where light is likely to be incident, it is possible to reduce diffusion of external light to prevent white blur in the screen from occurring.

In a case where the external light is likely to be incident on the top of the display panel as in the above example, the arithmetic average roughness (Ra) of fine uneven shape 46b of an upper part may be set to be smaller than the arithmetic average roughness (Ra) of fine uneven shape 46c of the lower part and the root mean average roughness (Rms) of fine uneven shape 46b of the upper part may be set to be smaller than the root mean average roughness (Rms) of fine uneven shape 46c the lower part.

As numerical values of the arithmetic average roughness (Ra) and the root mean average roughness (Rms), for example, in fine uneven shape 46b of the upper part, the arithmetic average roughness (Ra) is more than 0.08 µm and less than 0.15 µm and the root mean average roughness (Rms) is more than 80 nm and less than 150 nm. In fine uneven shape 46c of the lower part, the arithmetic average roughness (Ra) is more than 0.08 µm and less than 0.2 µm and the root mean average roughness (Rms) is more than 80 nm and less than 200 nm.

Although in an aspect shown in FIGS. 6A and 6B, fine uneven shape 46b of upper part and fine uneven shape 46c of the lower part are provided, the present embodiment is not limited to the aspect. For example, according to a use of the cover component, in a case where the external light is biased in a right and left direction, the above effect can be obtained by disposing two kinds of fine uneven shapes on the left and right. In addition, considering the biasing of the external light, disposition of fine uneven shapes should be considered.

Although the present embodiment adopts an aspect in which two kinds of fine uneven shapes 46b and 46c are provided, the cover component of the present embodiment is not limited to the aspect, and may adopt an aspect in which three or more kinds of the fine uneven shapes each of which has a different arithmetic average roughness (Ra) and a different root mean average roughness (Rms) are provided.

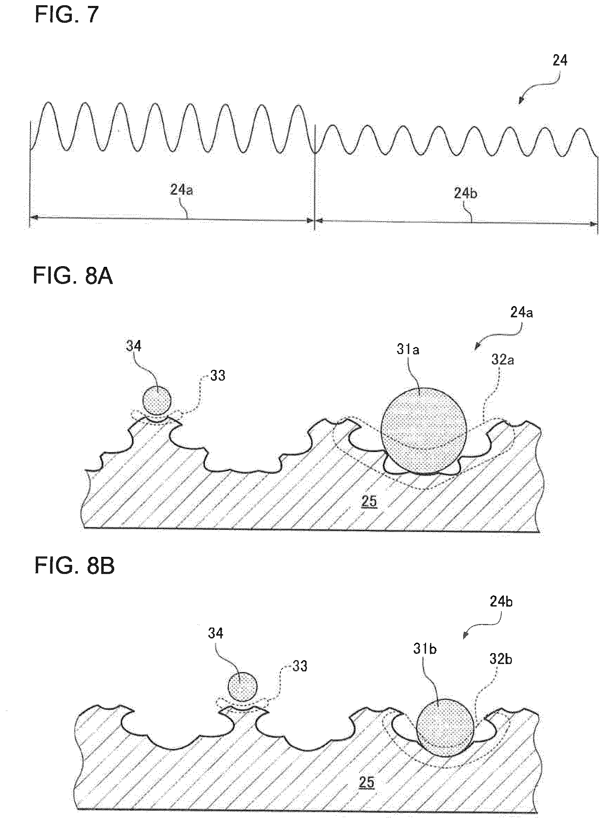

Next, a manufacturing apparatus and a manufacturing method of cover component 2 of the present embodiment will be described with reference to FIGs. 7 to 8B. Since approximate configurations of the manufacturing apparatus are the same as the configurations described with reference to FIGs. 4A and 4B in Embodiment 1, descriptions of the same configurations will be omitted. In the present embodiment, a sectional shape of fine uneven shape 24 of projection portion 25 of first die 21 is different from the shape of fine uneven shape 24 in Embodiment 1 described with reference to FIG. 5.

FIG. 7 is a schematic sectional view of fine uneven shape 24 of projection portion 25 of first die 21. Fine uneven shape 24 includes two kinds of fine uneven shapes 24a and 24b. FIG. 7 is a simplified schematic vies of fine uneven shapes 24a and 24b. A more detailed shape of fine uneven shape 24a is shown in FIG. 8A, and a more detailed shape of fine uneven shape 24b is shown in FIG. 8B. As shown in FIGS. 8A and 8B, these two kinds of fine uneven shapes 24a and 24b are respectively configured of two-steps of uneven shapes which are a first uneven shape and a second uneven shape. In order to form such two-steps of uneven shapes, the following method is exemplified.

First, when projecting glass bead 31a having a large diameter of #60 to a portion of projection portion 25 as shown in FIG. 8A, first uneven shape 32a having the arithmetic average roughness (Ra) of approximately 1.2 µm, the root mean average roughness (Rms) of approximately 80 nm can be formed on the surface of projection portion 25.

Thereafter, when projecting glass bead 31b of #80 to a position where first uneven shape 32a of projection portion 25 is not formed as shown in FIG. 8B, first uneven shape 32b having the arithmetic average roughness (Ra) of approximately 1.0 µm, the root mean average roughness (Rms) of approximately 70 nm can be formed on the surface where first uneven shape 32a of projection portion 25 is not formed.

When projecting glass bead 34 having a small diameter such as #320 to #600 on a whole projection portion 25 as shown in FIGs. 8A and 8B, second uneven shape 33 having a root mean average roughness (Rms) of approximately 50 nm can be formed on the surfaces of first uneven shapes 32a and 32b.

That is, Embodiment 1 adopts an aspect in which one kind of first uneven shape 32 is provided on the surface of projection portion 25 as shown in FIG. 5, whereas in Embodiment 2, two kinds of fine uneven shapes 46a and 46b (see FIGS. 6A, 6B) are provided on the surface of anti-reflection region 46 of cover component 2. Therefore, as shown in FIGS. 8A and 8B, two kinds of first uneven shapes 32a and 32b are also provided on the surface of projection portion 25 of the manufacturing apparatus.

### (Embodiment 3)

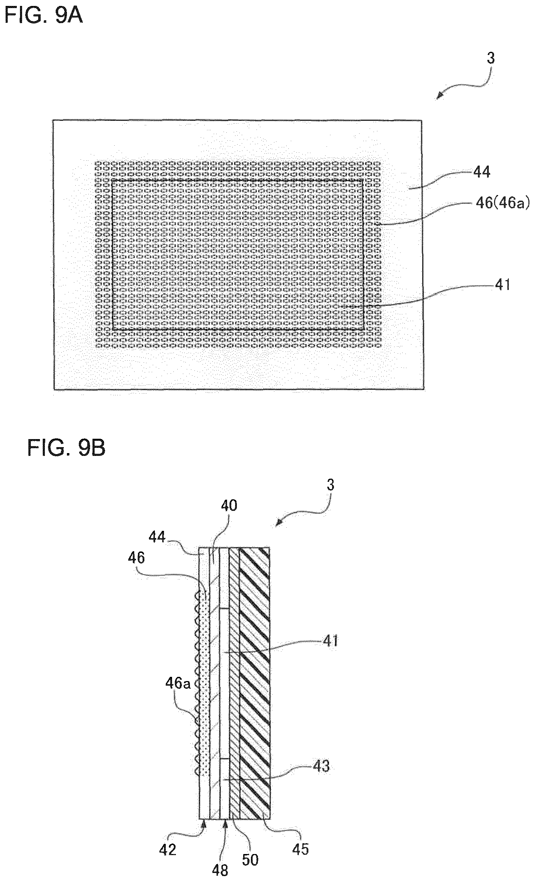

FIG. 9A is a plan view of a cover component of Embodiment 3. FIG. 9B is a side sectional view of the cover component. Hereinafter, the detailed description of the same configurations as the configurations in Embodiment 1 will be omitted, and only different points will be mentioned.

Cover component 3 of Embodiment 3 includes chromaticity adjustment layer 40 between hard coat layer 42 and decorative layer 48. A thickness of chromaticity adjustment layer 40 is formed to be several µm. Chromaticity adjustment layer 40 contains a very small amount of yellow coloring agent (pigment or dye).

In general, due to deterioration over time of the cover component, the light diffusing in fine uneven shape 46a of the surface of anti-reflection region 46 is more likely to be reflected as the wavelength is shorter. Therefore, light having a short wavelength, such as blue light enters eyes of the viewer. Accordingly, a blue tinge appears. On the other hand, in the present embodiment, since chromaticity adjustment layer 40 containing a yellow coloring agent is provided, even if the blue light is likely to be reflected by the deterioration over time of the cover component, chromaticity adjustment layer 40 supplements the yellow tinge, so that tinges of colors can be canceled each other. Therefore, even if the cover component deteriorates over time in places where irradiation of external light is strong, such as inside the vehicle or mobile device, it is possible to maintain neutral color tone.

In addition, chromaticity adjustment layer 40 preferably contains a UV absorber in addition to the yellow coloring agent. According to the aspect, the UV (ultraviolet) absorber improves the weather resistance of underlying transmissive substrate 45 or the display panel itself, and can prevent a molecular complex of the resin from being attacked by ultraviolet light. Therefore, it is possible to prevent a light absorption band of the resin from being shifted to a longer wavelength side due to deterioration over time and absorbing in a blue region. It is possible to further maintain the neutral color tone.

Although, in FIGs. 9A and 9B, an aspect in which single kind of fine uneven shape 46a is provided on the surface of hard coat layer 42 is illustrated, the cover component of the present embodiment is not limited to the aspect. That is, as in Embodiment 2, an aspect in which two or more kinds of fine uneven shapes are provided on the surface of the hard coat layer 42 may be adopted.

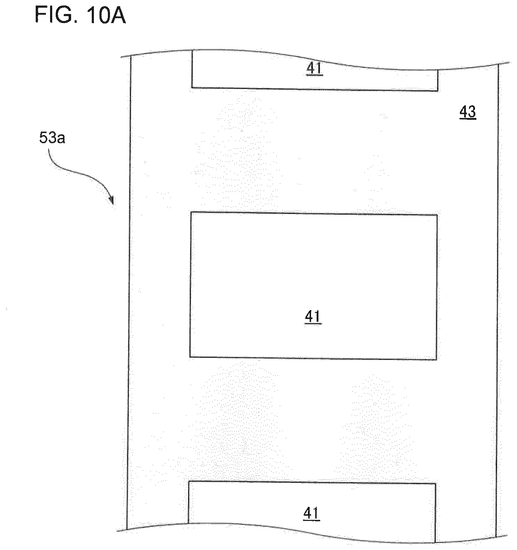

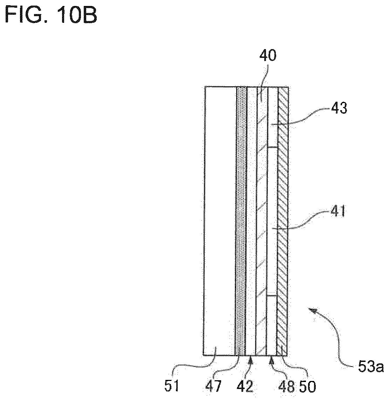

FIGs. 10A and 10B show an example of transfer film 53a used for manufacturing cover component 3 of the present embodiment. Unlike transfer film 53 described in Embodiment 1, chromaticity adjustment layer 40 is provided between hard coat layer 42 and decorative layer 48. Chromaticity adjustment layer 40 is also formed by vacuum film formation, gravure printing, screen printing, ink jet printing, or the like. Since a manufacturing apparatus and a manufacturing method of cover component 3 are the same as the manufacturing apparatus and the manufacturing method of Embodiment 1, a detailed description will be omitted.

### INDUSTRIAL APPLICABILITY

The present disclosure is useful for a cover component that covers a surface of a display panel of an in-vehicle display device, a mobile device, or the like.

### REFERENCE MARKS IN THE DRAWINGS

1, 2, and 3 COVER COMPONENT
21 FIRST DIE
22 SECOND DIE
24, 24a, 24b, 46a, 46b, and 46c FINE UNEVEN SHAPE
27 SUCTION HOLE
28 VACUUM PUMP
32, 32a, 32b, and 46aa FIRST UNEVEN SHAPE
33 and 46ab SECOND UNEVEN SHAPE
40 CHROMATICITY ADJUSTMENT LAYER
41 TRANSMISSIVE REGION
42 HARD COAT LAYER (ANTI-REFLECTION LAYER)
43 COLORED REGION
45 TRANSMISSIVE SUBSTRATE
46 ANTI-REFLECTION REGION
47 PEELABLE LAYER
48 DECORATIVE LAYER
50 ADHESIVE LAYER
51 BASE FILM
53 and 53a TRANSFER FILM

## Claims

1. A cover component (1) for covering a surface of a display panel, the cover component (1) comprising:
a decorative layer (48) that includes a colored region (43) having a frame shape and a transmissive region (41) provided on an inside of the colored region (43); and
a hard coat layer (42) that includes an anti-reflection region (46) and a region (44) having a smooth shape around the anti-reflection region (46), the anti-reflection region being a region having a fine uneven shape (46a, 46b, 46c) formed on at least one surface of the hard coat layer (42),
wherein the hard coat layer (42) overlaps the decorative layer (48), and
the anti-reflection region (46) covers the transmissive region (41) and protrudes into the colored region (43) over a whole inner peripheral portion of the colored region.

2. The cover component (1) of Claim 1,
wherein a dimension of the anti-reflection region (46) protruding into the colored region (43) is 0.05 mm or more and 0.25 mm or less.

3. The cover component (1) of Claim 1,
wherein in the fine uneven shape (46a, 46b, 46c), an arithmetic average roughness (Ra) is more than 0.08 µm and less than 0.2 µm, and a root mean average roughness (Rms) is more than 80 nm and less than 200 nm.

4. The cover component (1) of Claim 1,
wherein two or more kinds of fine uneven shapes (46b, 46c) are formed on at least one surface of the anti-reflection region (46), and
the two or more kinds of fine uneven shapes (46b, 46c) are different in an arithmetic average roughness (Ra) and a root mean average roughness (Rms).

5. The cover component (1) of Claim 4,
wherein the fine uneven shapes include:
a first uneven shape (32, 32a, 32b, 46b); and
a second uneven shape (46c) which is formed on a surface of the first uneven shape (46b), and has an arithmetic average roughness (Ra) and a root mean average roughness (Rms) respectively smaller than an arithmetic average roughness (Ra) and a root mean average roughness (Rms) of the first uneven shape.

6. The cover component (1) of Claim 1, further comprising:
a chromaticity adjustment layer (40) which is provided between the hard coat layer (42) and the decorative layer (48), and contains a yellow coloring agent.

7. The cover component (1) of Claim 6,
wherein the chromaticity adjustment layer (40) contains a UV absorber.

8. Use of a transfer film (53) for manufacturing the cover component (1) of Claim 1, the transfer film (53) comprising:
a base film (51) on which are stacked in the following order:
a peelable layer (47),
a hard coat layer (42), and
the decorative layer (48) of the cover component (1).

9. Use of a transfer film (53) for manufacturing the cover component (1) of Claim 5, the transfer film (53) comprising:
A base film (51) on which are stacked in the following order :
a peelable layer (47) ,
a hard coat layer (42), and
the decorative layer (48) of the cover component (1).

10. Use of a transfer film (53) for manufacturing the cover component (1) of Claim 7, the transfer film (53) comprising:
a base film (51) on which are stacked in the following order :
a peelable layer (47) ,
a hard coat layer (42), and
the decorative layer (48) of the cover component (1),
wherein the chromaticity adjustment layer (40) is interposed between the hard coat layer (42) and the decorative layer (48).

## Patentansprüche

1. Abdeckungskomponente (1) zum Abdecken einer Oberfläche eines Anzeigefelds, wobei die Abdeckungskomponente (1) umfasst:
eine dekorative Schicht (48), die eine farbige Region (43), die eine Rahmenform aufweist, und eine durchlässige Region (41) umfasst, die auf einer Innenseite der farbigen Region (43) bereitgestellt ist; und
eine Hartbeschichtungsschicht (42), die eine Anti-Reflexions-Region (46) und eine Region (44) umfasst, die eine glatte Form um die Anti-Reflexions-Region (46) herum umfasst, wobei die Anti-Reflexions-Region eine Region ist, die eine feine unebene Form (46a, 46b, 46c) aufweist, die auf mindestens einer Oberfläche der Hartbeschichtungsschicht (42) gebildet ist,
wobei die Hartbeschichtungsschicht (42) die dekorative Schicht (48) überlappt, und
die Anti-Reflexions-Region (46) die durchlässige Region (41) abdeckt und in die farbige Region (43) über einen gesamten inneren Umfangsabschnitt der farbigen Region hervorsteht.

2. Abdeckungskomponente (1) nach Anspruch 1,
wobei eine Abmessung der Anti-Reflexions-Region (46), die in die farbige Region (43) hervorsteht, 0,05 mm oder größer und 0,25 mm oder kleiner ist.

3. Abdeckungskomponente (1) nach Anspruch 1,
wobei in der feinen unebenen Form (46a, 46b, 46c) ein arithmetischer Mittelwert der Rauheit (Ra) größer als 0,08 µm und kleiner als 0,2 µm ist und ein quadratischer Mittelwert der Rauheit (Rms) größer als 80 nm und kleiner als 200 nm ist.

4. Abdeckungskomponente (1) nach Anspruch 1,
wobei zwei oder mehr Arten von feinen unebenen Formen (46b, 46c) auf mindestens einer Oberfläche der Anti-Reflexions-Region (46) gebildet sind, und
die zwei oder mehr Arten von feinen unebenen Formen (46b, 46c) sich in einem arithmetischen Mittelwert der Rauheit (Ra) und einem quadratischen Mittelwert der Rauheit (Rms) unterscheiden.

5. Abdeckungskomponente (1) nach Anspruch 4,
wobei die feinen unebenen Formen umfassen:
eine erste unebene Form (32, 32a, 32b, 46b); und
eine zweite unebene Form (46c), die auf einer Oberfläche der ersten unebenen Form (46b) gebildet ist, und einen arithmetischen Mittelwert der Rauheit (Ra) und einen quadratischen Mittelwert der Rauheit (Rms) aufweist, die kleiner als ein arithmetischer Mittelwert der Rauheit (Ra) beziehungsweise ein quadratischer Mittelwert der Rauheit (Rms) der ersten unebenen Form sind.

6. Abdeckungskomponente (1) nach Anspruch 1, ferner umfassend:
eine Farbort-Anpassungsschicht (40), die zwischen der Hartbeschichtungsschicht (42) und der dekorativen Schicht (48) bereitgestellt ist und ein gelbes Farbmittel enthält.

7. Abdeckungskomponente (1) nach Anspruch 6,
wobei die Farbort-Anpassungsschicht (40) einen UV-Absorber enthält.

8. Verwendung einer Transferfolie (53) zur Herstellung der Abdeckungskomponente (1) nach Anspruch 1, wobei die Transferfolie (53) umfasst:
eine Basisfolie (51), auf der in der folgenden Reihenfolge gestapelt sind:
eine abziehbare Schicht (47),
eine Hartbeschichtungsschicht (42), und
die dekorative Schicht (48) der Abdeckungskomponente (1).

9. Verwendung einer Transferfolie (53) zur Herstellung der Abdeckungskomponente (1) nach Anspruch 5, wobei die Transferfolie (53) umfasst:
eine Basisfolie (51), auf der in der folgenden Reihenfolge gestapelt sind:
eine abziehbare Schicht (47),
eine Hartbeschichtungsschicht (42), und
die dekorative Schicht (48) der Abdeckungskomponente (1).

10. Verwendung einer Transferfolie (53) zur Herstellung der Abdeckungskomponente (1) nach Anspruch 7, wobei die Transferfolie (53) umfasst:
eine Basisfolie (51), auf der in der folgenden Reihenfolge gestapelt sind:
eine abziehbare Schicht (47),
eine Hartbeschichtungsschicht (42), und
die dekorative Schicht (48) der Abdeckungskomponente (1),
wobei die Farbort-Anpassungsschicht (40) zwischen der Hartbeschichtungsschicht (42) und der dekorativen Schicht (48) zwischengelegt ist.

## Revendications

1. Composant de revêtement (1) pour couvrir une surface d'un panneau d'affichage, le composant de revêtement (1) comprenant :
une couche décorative (48) qui inclut une région colorée (43) ayant une forme de cadre et une région transmissive (41) disposée sur l'intérieur de la région colorée (43) ; et
une couche de couverture dure (42) qui inclut une région antireflet (46) et une région (44) ayant une forme lisse autour de la région antireflet (46), la région antireflet étant une région ayant une forme irrégulière fine (46a, 46b, 46c) formée sur au moins une surface de la couche de couverture dure (42),
dans lequel la couche de couverture dure (42) recouvre la couche décorative (48), et
la région antireflet (46) couvre la région transmissive (41) et s'étend dans la région colorée (43) sur toute la portion périphérique intérieure de la région colorée.

2. Composant de revêtement (1) selon la revendication 1, dans lequel la dimension de la région antireflet (46) s'étendant dans la région colorée (43) est de 0,05 mm ou plus et 0,25 mm ou moins.

3. Composant de revêtement (1) selon la revendication 1, dans lequel, dans la forme irrégulière fine (46a, 46b, 46c), la rugosité arithmétique moyenne (Ra) est supérieure à 0,08 µm et inférieure à 0,2 um, et la rugosité quadratique moyenne (Rms) est supérieure à 80 nm et inférieure à 200 nm.

4. Composant de revêtement (1) selon la revendication 1, dans lequel deux ou plus de deux types de formes irrégulières fines (46b, 46c) sont formées sur au moins une surface de la région antireflet (46), et les deux ou plus de deux types de formes irrégulières fines (46b, 46c) ont des rugosités arithmétiques moyennes (Ra) et des rugosités quadratiques moyennes (Rms) différentes.

5. Composant de revêtement (1) selon la revendication 4, dans lequel les formes irrégulières fines comprennent :
une première forme irrégulière (32, 32a, 32b, 46b) ; et
une deuxième forme irrégulière (46c) qui est formée sur une surface de la première forme irrégulière (46b), et a une rugosité arithmétique moyenne (Ra) et une rugosité quadratique moyenne (Rms) respectivement inférieures à la rugosité arithmétique moyenne (Ra) et à la rugosité quadratique moyenne (Rms) de la première forme irrégulière.

6. Composant de revêtement (1) selon la revendication 1, comprenant en outre une couche d'ajustement de chromaticité (40) qui est disposée entre la couche de couverture dure (42) et la couche décorative (48), et contient un agent colorant jaune.

7. Composant de revêtement (1) selon la revendication 6, dans lequel la couche d'ajustement de chromaticité (40) contient un absorbeur UV.

8. Utilisation d'un film de transfert (53) pour fabriquer le composant de revêtement (1) de la revendication 1, le film de transfert (53) comprenant :
un film de base (51) sur lequel sont empilées, dans l'ordre suivant :
une couche pelable (47),
une couche de couverture dure (42), et
la couche décorative (48) du composant de revêtement (1).

9. Utilisation d'un film de transfert (53) pour fabriquer le composant de revêtement (1) de la revendication 5, le film de transfert (53) comprenant :
un film de base (51) sur lequel sont empilées, dans l'ordre suivant :
une couche pelable (47),
une couche de couverture dure (42), et
la couche décorative (48) du composant de revêtement (1).

10. Utilisation d'un film de transfert (53) pour fabriquer le composant de revêtement (1) de la revendication 7, le film de transfert (53) comprenant :
un film de base (51) sur lequel sont empilées, dans l'ordre suivant :
une couche pelable (47),
une couche de couverture dure (42), et
la couche décorative (48) du composant de revêtement (1),
dans laquelle la couche d'ajustement de chromaticité (40) est interposée entre la couche de couverture dure (42) et la couche décorative (48).
